(19) Europäisches Patentamt
European Patent Office
Office européen des brevets

(11) Publication number: **0 145 973**
**B1**

(12) **EUROPEAN PATENT SPECIFICATION**

(45) Date of publication of patent specification: **12.09.90**

(51) Int. Cl.$^5$: **G 03 F 7/26**

(21) Application number: **84113854.8**

(22) Date of filing: **16.11.84**

(54) **Positive photoresist stripping composition.**

(30) Priority: **20.12.83 US 563336**

(43) Date of publication of application:
**26.06.85 Bulletin 85/26**

(45) Publication of the grant of the patent:
**12.09.90 Bulletin 90/37**

(84) Designated Contracting States:
**AT DE FR GB IT NL**

(56) References cited:
**EP-A-0 075 328**
**EP-A-0 075 329**
**US-A-4 090 879**

(73) Proprietor: **HMC Patents Holding Co., Inc.**
**Liberty Lane**
**Hampton New Hampshire (US)**

(72) Inventor: **Thomas, Evan Gower**
**c/o Allied Corporation P.O. Box 2245R**
**Morristown, NJ 07960 (US)**
Inventor: **Smalley, Edmund Walter**
**c/o Allied Corporation P.O. Box 2245R**
**Morristown, NJ 07960 (US)**
Inventor: **Cook, Kane David**
**c/o Allied Corporation P.O. Box 2245R**
**Morristown, NJ 07960 (US)**

(74) Representative: **Madgwick, Paul Roland et al**
**Ladas & Parry Isartorplatz 5**
**D-8000 München 2 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 145 973 B1

**Description**

This invention relates to novel strippers which are useful for removing positive photoresists primarily from substrates useful to integrated circuit manufacture. More particularly this invention relates to utilization of N-amino-alkylpiperazines and N-hydroxyalkylpiperazines either singly, together in admixture or diluted with certain polar solvent compositions for stripping positive photoresists.

In the manufacture of integrated circuits and related technology, organic composition are commonly used as stripper solutions for photoresists. Both positive and negative resists are stripped using mixtures drawn from a group of substances including phenolics, sulfonic acids, chlorocarbons and hydrocarbons. Several commercially available stripper solutions are constituted in this way. Chief among disadvantages for some of these products is the toxic and skin penetrating nature of some components making handling personally hazardous and waste disposal by conventional dumping and landfill procedures undesirable. The inclusion of hygroscopic sulfonic acid components tends to cause water absorption that leads to corrosivity towards semiconductor substrate metals. Reaction between aluminum metal and chlorocarbon can yield low levels of chloride on substrate surfaces which in turn translates into device damage through corrosion.

When photolithography device manufacture involves only positive photoresists, stripping may be done with a number of organic mixtures comprised of any of a number of polar solvents and mixtures of solvents. An indication of this is described by W. S. DeForest (Photoresist: Materials and Processes, McGraw-Hill, Inc. 1975). Some of these stripping compositions include dimethylformamide, N-methyl-2-pyrrolidone diethanolamine, triethanolamine, several glycol ethers (e.g., such as those available commercially under the brand names Cellosolv and Carbitol), and ketones (i.e. methylethylketone, acetone, methylisobutylketone, cyclohexanone). A number of stripper solutions currently on the market utilize mixtures of some of these organic solvents and are designed for use exclusively in removing positive resists.

The difficulty of photoresist stripping depends on process conditions used in device manufacture which may be determined by the type of device made. When most positive resists are cured by baking no higher than 150°C, removal using most solvent based stripping solutions is achieved at relatively low temperatures near normal room temperature. With bake temperatures between 150° and 200°C photoresist stripping is more difficult and may require using higher temperatures for the stripping process. Where photoresist films or patterns are exposed to plasma and ion implantation conditions during dry processing, very hard to strip material is formed.

From experience with available stripper solutions, it has been found that mixtures comprised of "neutral" polar solvents such as amides (DMF, N-methyl-2-pyrrolidone) glycol ethers (Cellosolve, Carbitols) sulfones (e.g., sulfolanes), ketones (e.g., acetone, methylethylketones and the like) are practical for stripping easy to remove (not baked or baked at 135°C maximum) positive photoresists. For positive photoresists baked higher than 150° or exposed to plasma or ion implantation processing, it is often advantageous to use stripper solutions consisting of amines or amines diluted with neutral polar solvents.

It is desirable to operate photoresist stripping at low temperatures primarily for safety reasons minimizing both fire hazards from solvent fumes and contacting personnel with hot liquids and vapors. Lower temperature operation also minimizes problems from changing composition due to selective vaporization of more volatile components.

One of the major drawbacks in stripper solutions which are effective for very hard to strip material is that they usually contain environmentally hazardous or toxic ingredients such as phenolics or chlorinated hydrocarbons. Accordingly, a need exists for an improved environmentally safe, relatively non-toxic positive photoresist stripper which is effective in removing hard to strip positive photoresists.

The invention involves the use of substituted piperazines alone or diluted with certain polar solvents as stripper solutions for use on positive photoresist compositions. Using mixtures of these components allows overcoming of many problems associated with resist stripping. Components are relatively non-toxic allowing minimized hazards for use areas. For application with resists cured by thermal bake stripping at relatively low temperature (room temperature to 70°C) is practical. Components are sufficiently high boiling to allow high temperature operation when necessary to strip more difficult photoresist residues (i.e., plasma exposed and ion implant exposed photoresist). To that end adjustment in the composition is possible to allow for synergistic action between piperazine derived components.

According to the invention there is provided a stripper for removing an organic positive photoresist composition from the surface of a substrate containing such photoresist comprising (a) from 10% to 100% of at least one piperazine selected from the group consisting of piperazines of the formula

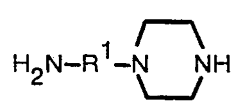

bis-N-aminoalkylpiperazines of the formula

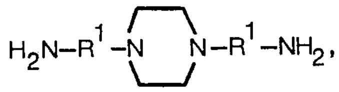

N-hydroxyalkylpiperazine of the formula

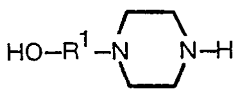

and bis-hydroxyalkylpiperazines with structure

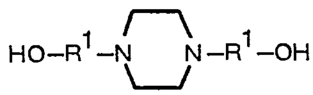

in which $R^1$ is a linear or branched alkylene group of the formula $-(CH_2)_n-$ in which n is 1—6 or a cycloalkyl group with 5 or 6 C atoms, and (b) an alkyl- or cycloalkyl-2-pyrrolidone of the formula

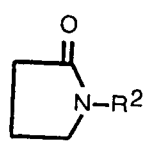

where $R^2$ is an alkyl group of 1—6 carbon atoms or a 5 or 6 member cycloalkyl, and including aminoalkyl and hydroxyalkyl of 1—6 carbon atoms or a polar organic component which is compatible with and substantial miscible in (a) in amounts of from about 90 percent by weight to about 0 percent by weight.

Other amide type solvents with a boiling point in excess of 200°C e.g., N-formylmorpholine, may also be incorporated in amounts of up to about 70 percent by weight. The stripper mixtures may also include glycol ethers having boiling points exceeding 200°C, e.g., nonoethyl, monobutyl, or monohexyl ethers of diethylene glycol.

The respective components in the strippers of the invention comprise N-aminoalkylpiperazine in a range between 0% and 90% by weight; N-hydroxyalkylpiperazine between 0% and 90% by weight provided that at least one of said piperazines is present in amounts of at least 10% by weight; N-methyl-2-pyrrolidone between 0% and 90% by weight and diethylene glycol monobutyl ether between 0% and 25% by weight. Preferred compositions for general application comprise between 2% and 15% by weight N-hydroxyalkylpiperazine, 10—30% by weight N-aminoalkylpiperazine, 0—20% by weight diethylene glycol monobutyl ether and 70—80% by weight N-methyl-2-pyrrolidone.

The novel strippers comprising the subject matter of the present invention which are useful for removing positive photoresists primarily from substrates useful to integrated circuit manufacture utilize N-aminoalkylpiperazines and N-hydroxyalkylpiperazines either singly or together in admixture or diluted with certain polar solvent compositions. Phenolics and chlorinated hydrocarbon compounds are excluded giving low toxicity and minimized waste disposal problems.

The substituted piperazines may be used alone or diluted with certain polar solvents as stripper solutions for positive photoresists. Using mixtures of these components allows overcoming of problems associated with resist stripping. And because the components used are relatively non-toxic, they present minimized hazards in the work areas. For application with resists cured by thermal bake stripping at relatively low temperature (room temperature to 70°C) is practical. Components are sufficiently high boiling to allow high temperature operation when necessary to strip more difficult photoresist residues (i.e., plasma exposed and ion implant exposed photoresist) with considerable adjustment possible in the composition to allow for optimum stripping action between piperazine derived components.

Included in the strippers of this invention are the N-aminoalkylpiperazines of the formula:

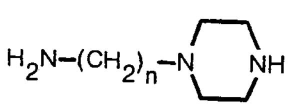

bis N-aminoalkylpiperazines of the formula

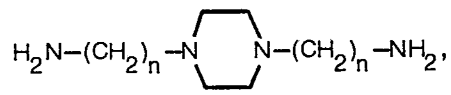

N-hydroxyalkylpiperazine of the formula

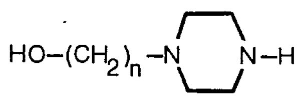

and bis-hydroxyalklypiperazines with structure

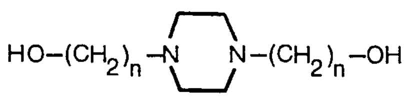

In the above formulae n = 1—6. Also included are piperazine derivatives such as those of the above formulae with a branch chain alkyl of 1—6 C atoms, and 5—6 C atom cycloalkyl substituted compounds wherein the cycloalkyl is substituted for $—(CH_2)_n—$. Components which may be mixed with the above described piperazine in preparing the positive photoresist stripping compositions of the invention include alkyl or cycloalkyl-2-pyrrolidones of the formula

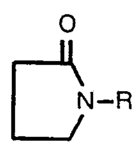

where R is an alkyl group of 1—6 carbon atoms or a 5 or 6 member cycloalkyl and including aminoalkyl and hydroxyalkyl of 1—6 carbon atoms. Other amide type solvents with a boiling point in excess of 200°C may also be incorporated into the strippers, for example, N-formylmorpholine and other polar organic compounds that are compatible with the above piperazines e.g., glycol ethers having boiling points exceeding 200°C (such as monoethyl, monobutyl, or monohexyl ethers of diethylene glycol) in amounts of up to about 70% by weight. The proportions of components in the piperazine containing stripper may vary within fairly broad limits, providing that at least one of the piperazines is present in an amount of at least 10% by weight, and include N-aminoethylpiperazine (NAEP) in a range between 0% and 90% by weight; N-hydroxyethyl piperazine (NHEP) between 0% and 90% by weight. Other components, e.g., N-methyl-2-pyrrolidone (NMP) may be incorporated in amounts of between 5% and 90% by weight; and butylcarbitol (BC) in amounts between 0% and 25% by weight. Preferred compositions for general application comprise combinations of hydroxyalkylpiperazines, especially hydroxyethylpiperazine and aminoalkyl piperazines, especially aminoethylpiperazine in the range by weight of 10%—30% by weight N-aminoethylpiperazine, 2%—15% by weight N-hydroxyethylpiperazine, and 70%—80% by weight N-methyl-2-pyrrolidone.

The invention will be further described by the following specific examples. It should be understood, however, that although these examples may describe in detail certain preferred operating conditions of the invention, they are given primarily for purposes of illustration, and the invention in its broader aspects is not limited thereto. Parts expressed are parts by weight unless otherwise stated.

In preparing the strippers of the invention, no particular order of addition need be employed. The various components are measured in the desired proportion and introduced into a suitable mixing vessel and thoroughly mixed by stirring. Any alternate suitable means to effectively intermix the components such as by concurrent introduction of streams of the respective components, or any other suitable known means that fully intersperse the components may be used. Once mixed, the stripping composition is stable, with no detectable separation of copmonents and has excellent shelf life.

The photoresist compositions employed are any of the commercially available organic photosensitizer alkaline soluble resin formulations which comprise (a) a suitable sensitizer such as diazo ketone compounds, e.g., naphthoquinone-1, 2-diazo sulfonic acid esters, (b) a novolak resin and (c) a suitable solvent such as xylene. Photoresists are generally described, for example, on page 67 in the work by D. J. Elliot in Integrated Circuit Fabrication Technology, McGraw-Hill Book Company, 1982.

Examples 1—6

Table 1 summarizes examples 1—6 showing comparative results in stripping 1 μ thick, non-patterned films of commercially available resist (Shipley 1470) prebaked at 90°C followed by final hard bake at 135°C and 200°C each for 30 minutes. The stripping method involved soaking coated wafers in a temperature controlled tank of stripping solution. The stripped wafers are rinsed in copious amounts of deionized water. After air drying completeness of strip was judged by visual inspection with and without moisture film deposition. From these examples, using strippers claimed by the present invention, the following attributes are noted:

a) Fast stripping of high temperature (200°C) baked resist can be accomplished at relatively low operating temperature.

b) Suitable fast stripping rates of resists baked up to 135°C can be effected by room temperature stripping.

TABLE I
Stripping Thermally Cured Positive Resist

| Example | Stripper Composition | 70°C Strip 200°C Bake | Room Temp. (25°C) Strip 135°C Bake |
|---|---|---|---|
| (1) | 70% NMP<br>30% NAEP | 4.5 min. | 3.5 min. |
| (2) | 10% NMP<br>90% (6/1-NAEP/NHEP) | 36 min. | 7.3 min. |
| (3) | 70% BC<br>30% NAEP | 36 min. | 30 min. |
| (4) | 70% NMP<br>30% (6/1-NAEP/NHEP) | 4 min. | 3 min. |
| (5) | 70% NMP<br>30% (2/1-NAEP/NHEP) | 3.7 min. | 3 min. |
| (6) | 70% NMP<br>30% NHEP | 1.5 min. | 2.25 min. |

Examples 7—10

Examples 7—10 employed the same stripping method described with reference to Examples 1—6 except resist patterns were stripped at 150°C and evaluated visually at 100 magnification; the results are summarized in Table II. These examples in a relative way demonstrate the following:

a) Stripping plasma and ion implant exposed photoresist requires relatively high stripping temperatures.

b) Synergistic effects are indicated among the three components. Examples 9, 11 and 12 show a region in plasma stripping of constant NAEP/NHEP ratio with a maximum stripping rate in the vicinity of 12% NMP. Examples 7, 9 and 10 suggest a maximum stripping rate in ion implant stripping over a range of NAEP/NHEP ratios.

c) Effectiveness for stripping boron ion implanted wafers occurs with different mixtures than those effective with plasma exposed resist.

TABLE II
High Energy Exposed

| Example | Stripper Composition | $CF_4/O_2$ Plasma | Boron Ion Implant |
|---|---|---|---|
| (7) | NAEP 76%<br>NHEP 12%<br>NMP 12 | 60% stripped<br>60 min. | 100% stripped<br>60 min. |
| (8) | NAEP 81<br>NHEP 14<br>NMP 5 | 30% stripped<br>60 min. | 40% stripped<br>60 min. |
| (9) | NAEP 70<br>NHEP 18<br>NMP 12 | 90% stripped<br>60 min. | 40% stripped<br>60 min. |
| (10) | NAEP 58%<br>NHEP 30<br>NMP 12 | 80% stripped<br>60 min. | 35% stripped<br>60 min. |
| (11) | NAEP 76<br>NHEP 19<br>NMP 5 | 15% stripped<br>60 min. | 30% stripped<br>60 min. |
| (12) | NAEP 64<br>NHEP 16<br>NMP 20 | 30% stripped<br>60 min. | 35% stripped<br>60 min. |

The positive photoresist stripper of the invention allows operation at relatively low temperatures which is advantageous for safety reasons and especially because lower temperatures minimize the fire hazard from solvent fumes which would pose a greater danger to personnel when hot liquids and vapors are present. Additionally, the lower temperature substantially facilitates renewal of the stripping solutions during operations. Also, operation at lower temperature reduces vaporization which can lead to an objectionable change in the stripping solution composition.

## Claims

1. A stripper for removing an organic positive photoresist composition from the surface of a substrate containing such photoresist comprising (a) from 10% to 100% of at least one piperazine selected from the group consisting of piperazines of the formula

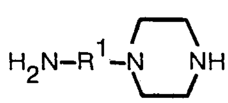

bis-N-aminoalkylpiperazines of the formula

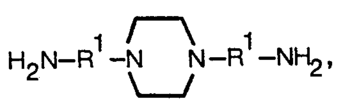

N-hydroxyalkylpiperazine of the formula

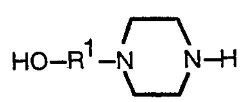

and bis-hydroxyalkylpiperazines with structure

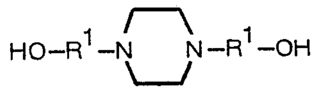

in which $R^1$ is a linear or branched alkylene group of the formula $-(CH_2)_n-$ in which n is 1—6 or a cycloalkyl group with 5 or 6 C atoms, and (b) an alkyl- or cycloalkyl-2-pyrrolidone of the formula

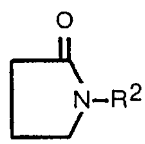

where $R^2$ is an alkyl group of 1—6 carbon atoms or a 5 or 6 member cycloalkyl, and including aminoalkyl and hydroxyalkyl of 1—6 carbon atoms or a polar organic component which is compatible with and substantial miscible in (a) in amounts of from about 90 percent by weight to about 0 percent by weight.

2. The stripper of claim 1 wherein (a) comprises a blend of N-aminoethylpiperazine and N-hydroxyethylpiperazine.

3. The stripper of claim 1 wherein $R^2$ of component (b) is selected from an alkyl group of 1—6 carbon atoms; aminoalkyl-N-pyrrolidones and hydroxyalkyl-2-pyrrolidones where the alkyl group comprises 1—6 carbon atoms; monoethyl ether of diethylene glycol, monobutyl ether of diethylene glycol, monohexyl ether of diethylene glycol formylmorpholine and mixtures thereof.

4. The stripper of claim 2 wherein the (b) component comprises N-methyl-2-pyrrolidone.

5. The stripper of claim 2 wherein (a) comprises a blend of N-aminoethylpiperazine and N-hydroxyethylpiperazine in a ratio respectively of 1:1 to about 10:1 in an amount of about 30 percent by weight and (b) comprises N-methyl-2-pyrrolidone in an amount of about 70 percent by weight.

6. A method of stripping positive photoresist from a substrate surface having a layer of said photoresist applied thereon comprising contacting the photoresist layer with the stripper of claim 1 at a temperature between about 15°C and about 160°C until said photoresist is substantially removed.

## Patentansprüche

1. Abstreifmittel zum Entfernen einer organischen positiven Photolackzusammensetzung von der Oberfläche eines diesen Photolack enthaltenden Substrats, mit

(a) 10 bis 100% mindestens eines Piperazins, das aus der Gruppe ausgewählt ist, die aus den Piperazinen der Formel

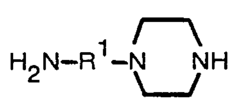

den Bis-N-Aminoalkylpiperazinen der Formel

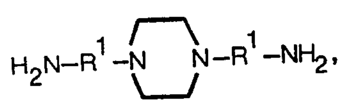

den B-Hydroxyalkylpiperazinen der Formel

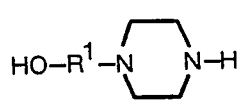

und den Bis-Hydroxyalkylpiperazinen der Struktur

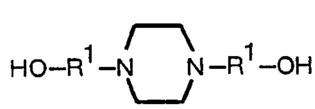

besteht, wobei $R^1$ eine lineare oder verzweigte Alkylengruppe der Formel $—(CH_2)_n—$ ist, in der n 1 bis 6 ist, oder eine Cycloalkylgruppe mit 5 oder 6 C-atomen, und mit

(b) einem Alkyl- oder Cycloalkyl-2-Pyrrolidon der Formel

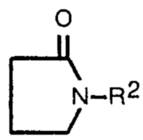

in der $R^2$ eine Alkylgruppe mit 1 bis 6 Kohlenstoffatomen oder ein 5- oder 6-gliedriges Cycloalkyl ist und ein Aminoalkyl und ein Hydroxyalkyl mit 1 bis 6 Kohlenstoffatomen oder eine polare organische Komponente aufweist, die mit (a) verträglich und in Mengen von etwa 90 Gew.-% bis etwa 0 Gew.-% im wesentlichen mischbar ist.

2. Abstreifmittel nach Anspruch 1, dadurch gekennzeichnet, daß (a) wenigstens teilweise aus einem Gemisch von N-Aminoethylpiperazin und N-Hydroxyethylpiperazin besteht.

3. Abstreifmedium nach Anspruch 1, dadurch gekennzeichnet, daß $R^2$ in der Komponente (b) ausgewählt ist aus einer Alkylgruppe mit 1 bis 6 Kohlenstoffatomen; Aminoalkyl-N-Pyrrolidonen und Hydroxyalkyl-2-Pyrrolidonen, in denen die Alkylgruppe 1 bis 6 Kohlenstoffatome besitzt; Diethylenglykolmonoethylether, Diethylenglykolmonobutylether, Diethylenglykolmonohexylether, Formylmorpholin und Gemischen derselben.

4. Abstreifmittel nach Anspruch 2, dadurch gekennzeichnet, daß die Komponente (b) mindestens teilweise aus N-Methyl-2-pyrrolidon besteht.

5. Abstreifmittel nach Anspruch 2, dadurch gekennzeichnet, daß (a) ein Gemisch von N-Aminoethylpiperazin und N-Hydroxyethylpiperazin im Verhältnis von 1:1 bis etwa 10:1 in einer Menge von etwa 30 Gew.-% und (b) N-Methyl-2-pyrrolidon in einer Menge von etwa 70 Gew.-% enthält.

6. Verfahren zum Abstreifen eines positiven Photolackes von einer mit einer Schicht aus dem Photolack versehenen Oberfläche eines Substrats, in dem die Photolackschicht mit dem Abstreifmittel nach Anspruch 1 bei einer Temperatur zwischen etwa 15°C und etwa 160°C in Berührung gebracht wird, bis der Photolack im wesentlichen entfernt ist.

**Revendications**

1. Extracteur pour l'enlèvement d'une composition photorésist positive organique d'une surface d'un substrat contenant un tel photorésist comprenant (a) de 10 à 100% d'au moins une pipérazine choisie parmi l'ensemble constitué par les pipérazines de formule:

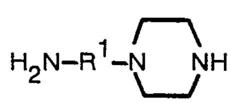

les bis-N-aminoalkylpipérazines de formule:

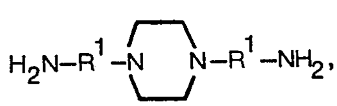

les N-hydroxyalkylpipérazines de formule:

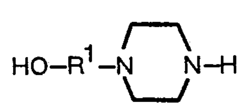

et les bis-hydroxyalkylpipérazines de formule:

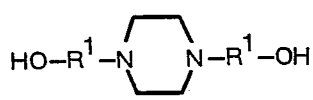

dans lesquelles $R^1$ est un groupe alkylène linéaire ou ramifié de formule $-(CH_2)_n-$ où n a pour valeur 1 à 6 ou un groupe cycloalkyle ayant de 5 à 6 atomes de carbone, et (b) une alkyl- ou cycloalkyl-2-pyrrolidone de formule:

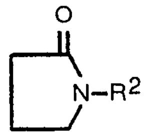

où $R^2$ est un groupe alkyle en $C_1$—$C_6$ ou un groupe cycloalkyle en $C_5$—$C_6$, et comprenant un composant aminoalkyle et hydroxy-alkyle ayant de 1 à 6 atomes de carbone ou un composant organique polaire qui est compatible avec et essentiellement miscible dans (a) selon des quantités variant entre environ 90% en poids et 0% en poids.

2. Extracteur selon la revendication 1 dans lequel (a) comprend un mélange de N-aminoéthylpipérazine et N-hydroxyéthylpipérazine.

3. Extracteur selon la revendication 1 dans lequel le groupe $R^2$ du composant (b) est choisi parmi un groupe alkyle ayant de 1 à 6 atomes de carbone; les aminoalkyl-N-pyrrolidones et N-hydroxyalkyl-2-pyrrolidones où le groupe alkyle comprend de 1 à 6 atomes de carbone; les monoéthyléther de diéthylèneglycol, monobutyléther de diéthylèneglycol, monohexyléther de diéthylèneglycol, formylmorpholine et leurs mélanges.

4. Extracteur selon la revendication 2 dans lequel le composant (b) comprend la N-méthyl-2-pyrrolidone.

5. Extracteur selon la revendication 2 dans lequel (a) comprend un mélange de N-aminoéthylpipérazine et N-hydroxyéthylpipérazine dans un rapport respectivement de 1/1 à environ 10/1 et selon une quantité d'environ 30% en poids et (b) comprend la N-méthyl-2-pyrrolidone selon une quantité d'environ 70% en poids.

6. Procédé d'extraction d'un photorésist positif d'une surface de substrat sur laquelle est appliquée une couche dudit photorésist, consistant à mettre en contact la couche de photorésist avec l'extracteur de la revendication 1 à une température comprise environ entre 15°C et 160°C jusqu'à ce que ledit photorésist soit essentiellement enlevé.